# EUROPÄISCHE PATENTSCHRIFT

(11) **EP 0 947 281 B1**
(45) Veröffentlichungstag und Bekanntmachung des Hinweises auf die Patenterteilung: **27.03.2002**
(21) Anmeldenummer: 98124759.6
(22) Anmeldetag: 28.12.1998
(51) Int. Cl.: B23K 26/00, B23K 20/02

(54) **Vorrichtung und Verfahren zum Thermokompressionsbonden**
Device and method for thermo-compression bonding
Dispositif et procédé pour joindre par thermo-compression

(30) Priorität: 30.03.1998 DE 19814118
(43) Veröffentlichungstag der Anmeldung: 06.10.1999
(73) Patentinhaber: F & K Delvotec Bondtechnik GmbH, 85521 Ottobrunn (DE); HAHN-SCHICKARD-GESELLSCHAFT FÜR ANGEWANDTE FORSCHUNG E.V., D-78052 Villingen-Schwenningen (DE)
(72) Erfinder: Farassat, Farhad, Dr., 82024 Taufkirchen (DE); Alavi, Mani Dr., 78050 VS-Villingen (DE); Burger, Volker, 89073 Ulm (DE); Faist, Joachim, 78713 Schramberg (DE); Pollak, Klaus, 78144 Tennenbronn (DE); Schmidt, Bertram, Dr., 78052 VS-Villingen (DE)
(74) Vertreter: Popp, Eugen, Dr.

(56) Entgegenhaltungen:
- EP-A- 0 367 705
- US-A- 4 534 811
- US-A- 4 893 742
- PATENT ABSTRACTS OF JAPAN vol. 007, no. 186 (E-193), 16. August 1983 & JP 58 089831 A (HITACHI SEISAKUSHO KK), 28. Mai 1983
- PATENT ABSTRACTS OF JAPAN vol. 008, no. 009 (M-268), 14. Januar 1984 & JP 58 173093 A (TOKYO SHIBAURA DENKI KK), 11. Oktober 1983
- HUSSEY B W ET AL: "INTRINSIC THERMOCOUPLE MONITOR FOR LASER WIREBONDING" IEEE TRANSACTIONS ON COMPONENTS, PACKAGING AND MANUFACTURING TECHNOLOGY: PART A, Bd. 18, Nr. 1, 1. März 1995, Seiten 206-213, XP000493571

## Beschreibung

Die Erfindung betrifft eine Vorrichtung zum Thermokompressionsbonden mit einem gegen eine Bondstelle verfahrbaren Kontaktierwerkzeug (Wedge) und einem diesem zugeordneten, mit einer Laserstrahlquelle gekoppelten Lichtwellenleiter gemäß dem Oberbegriff des Anspruches 1, sowie ein entsprechendes Thermokompressionsbonden unter Verwendung eines Kontaktierwerkzeuges bzw. Wedge und einer Laserstrahlquelle.

Bei der Serienfertigung von Mikrosystemen der Hybridtechnik werden die Herstellungskosten zum größten Teil durch den Zeit- und Kostenaufwand beim Aufbau und bei der Konfektionierung der Produkte bestimmt. Im Prozeßabschnitt der Aufbau- und Verbindungstechnik findet ein Übergang von der Fertigung im Batch-Processing zu einer seriellen Bearbeitung der Einzelelemente statt. Eine rationelle und wirtschaftliche Fertigung von hybridaufgebauten Mikrosystemen hängt damit in hohem Maße von der Verfügbarkeit von zumindest teilweise automatisierbaren Montage- und Fügeeinrichtungen ab. Die hier interessierenden Fügeeinrichtungen dienen zur Ausführung einer elektrisch leitfähigen Verbindung von einem Chip zu einem Systemträger mittels eines sogenannten Bonddrahtes. Das entsprechende Verfahren wird ganz allgemein als "Wirebonden" bezeichnet. Man unterscheidet dabei drei grundsätzliche Verfahren, nämlich das Aluminiumdraht-Ultraschall-Wedge-Wedge-Bondverfahren, das Golddraht-Thermosonic-Nailhead-Wedge-Bondverfahren oder kurz genannt Thermosonic-Bondverfahren, und das reine Thermokompressionsbonden, das ohne Ultraschallenergie arbeitet. Das Thermokompressionsbonden zeichnet sich durch eine große Werkstoffauswahl, einfache Prozeßführung sowie ein breites Prozeßfenster aus. Das Verfahren eignet sich besonders zum Bonden von ultraschallempfindlichen Bauelementen. Nachteilig bei diesem Verfahren ist jedoch die relativ hohe Prozeßtemperatur von 280 °C bis 350 °C. Bei vielen Anwendungen ist eine Erwärmung des Gesamtsystems auf diese Temperatur aufgrund wärmeempfindlicher Systemkomponenten wie Schaltungsträgern, Gehäuseteilen oder dergleichen nicht möglich. Als typisches Beispiel kann ein hybridaufgebauter Drucksensor mit Signalverarbeitungselektronik in einem Kunststoffgehäuse genannt werden. Dementsprechend gilt es, eine Vorrichtung und ein Bondverfahren zu schaffen, mit der bzw. dem die erwähnte Prozeßtemperatur erreicht wird, ohne daß temperaturempfindliche mikromechanische Bauteile geometrisch verändert, beschädigt oder gar zerstört werden. Des weiteren gilt es, eine Vorrichtung und ein Bondverfahren zu schaffen, welches mit im Vergleich zum Stand der Technik erheblich geringerem Energieaufwand arbeitet.

Zu diesem Zweck ist bereits der Einsatz einer Laserstrahlquelle bzw. eines davon abgeleiteten Laserstrahls von der Anmelderin vorgeschlagen worden; denn der Laserstrahl ermöglicht eine Lokalisierung der Energie-Einkoppelung. Er ist auch fein dosierbar, d.h. auf die übrigen Bondbedingungen einstellbar. Im übrigen lassen sich die wesentlichen Vorteile des laserunterstützten Drahtbondens etwa wie folgt zusammenfassen:
- große Werkstoffauswahl bei Bonddraht und Metallisierungspad (Al, Au, Ni, Cu, Pd, etc.)
- einfache Prozeßführung und breites Prozeßfenster
- Möglichkeit der Verwendung von lackisolierten Drähten
- hohe mechanische Festigkeit der Bondverbindung
- Verwendung ultraschallempfindlicher Substrate.

Bei IBM Microelectronics (siehe Chalco, P.; Gupta, A.; Hussey, B.; Hodgson, R.; Arjavalingam, G.; "Discrete Wire Bonding Using Laser Energy", SEMI Conductor International, May 1988, S. 130; und Hussey B.; Arjavalingam, G.; Gupta, A.; Chalco, P.; Tong, H.; "Intrinsic Thermocouple Monitor for Laser Wire Bonding", IEEE Transactions on Components, Packaging and Manufacturing Technology - Part A. Vol 18, No. 1, March 1995, S. 206) wurde der Einsatz der Laserenergie zum Drahtbonden auf MLC-Modulen (multilayer ceramics) untersucht. Hierbei wurden lackisolierte und goldbeschichtete Kupferdrähte (Durchmesser: 55 µm) verwendet. Die benötigte Laserleistung von 20 bis 50 W wurde über einen - durch eine Bondkapillare geführten - Lichtwellenleiter auf die Kontaktstelle übertragen. Der thermoelektrische Effekt wurde zur Messung der Temperatur der Kontaktstelle genutzt. Damit kann durch die Regelung der Laserintensität eine vorgegebene Bondtemperatur unabhängig von den Randbedingungen konstant gehalten werden. Durch die Optimierung der Strahlparameter konnten für das oben dargestellte Kontaktsystem gut reproduzierbare Bondverbindungen mit einer Bruchfestigkeit von > 50 cN realisiert werden.

Nachteilig bei dem bekannten Verfahren ist der hohe Energieaufwand von 20 bis 50 Watt. Der Grund dafür liegt darin, daß durch den Laserstrahl primär das Wedge aufgeheizt wird, um am Bonddraht die erforderliche Prozeßtemperatur zu erhalten.

Eine Vorrichtung gemäß dem Oberbegriff von Anspruch 1 ist eberfalls aus der JP-A-58 089831 bekannt.

Der vorliegenden Erfindung liegt nun die Aufgabe zugrunde, die bekannten Vorrichtungen und die bekannten Verfahren dahingehend zu verbessern, daß mit minimalem Energieaufwand hochqualitative und reproduzierbare Bondverbindungen hergestellt werden können.

Diese Aufgabe wird erfindungsgemäß bei einer Vorrichtung der hier fraglichen Art durch die kennzeichnenden Merkmale des Anspruches 1 und hinsichtlich des Verfahrens durch die Merkmale des Anspruches 5 gelöst.

Dadurch, daß der Lichtwellenleiter erfindungsgemäß durch den Wedge hindurch bis unmittelbar zu dem sich unterhalb des Wedge befindlichen Bonddraht-Abschnitt hin geführt ist, wird die Laserleistung im wesentlichen nur in diesem Kontaktsystem-Abschnitt eingekoppelt. Damit erhält man eine räumlich konzentrierte Temperaturverteilung im Kontaktsystem, und zwar innerhalb kürzester Zeit mit der Folge, daß das Kontaktierwerkzeug bzw. der Wedge nur unwesentlich erwärmt wird. Dadurch bedingte Energieverluste sind entsprechend minimal. Versuche haben gezeigt, daß mit der erfindungsgemäßen Vorrichtung und dem erfindungsgemäßen Verfahren eine Laserleistung von 2 bis 5 Watt ausreicht. Die Folge ist, daß auf sehr preisgünstige Laserstrahlquellen zurückgegriffen werden kann, z.B. auf IR-Diodenlaser mit Ausgangsleistungen von etwa 5 Watt.

Die erfindungsgemäße Vorrichtung geht von einer Standard-Bondeinheit aus. Es ist lediglich noch erforderlich, eine Bohrung am Wedge vorzusehen, durch die hindurch der Lichtwellenleiter zur unteren Kontaktfläche des Wedge geführt wird. Der Lichtwellenleiter ist an der der Drahtzuführung gegenüberliegenden Seite des Wedge in diesen eingeführt, und zwar unter einem Winkel von 30 bis 50 Grad, insbesondere etwa 40° bis 45° zur Vertikalen bzw. Anpressrichtung des Wedge. Der Lichtwellenleiter ist dabei vorzugsweise mittels einer speziellen Klemmvorrichtung am Wedge befestigt.

Der Lichtwellenleiter ist über einen optischen Schalter mit einer Laserstrahlquelle, insbesondere Laserdiode, gekoppelt, wobei Laserquelle und/oder Shutter durch eine Steuereinrichtung in Abhängigkeit vom Bondzyklus ansteuerbar ist.

Wie bereits dargelegt, zeichnet sich das erfindungsgemäße Verfahren durch eine Einkoppelung der Laserenergie in den Kontaktsystem-Abschnitt aus. Die benötigte Temperatur wird nach einer Zeitspanne von nur etwa 100 ms bis 300 ms, insbesondere etwa 150 ms erreicht. Trotz dieser kurzen Zeitspanne wird aufgrund der unmittelbaren Beaufschlagung des Bonddrahtes und des Bondpads mit Laserenergie die zum Thermokompressionsbonden erforderliche Prozeßtemperatur von etwa 350 °C erreicht, ohne daß umliegende Bauteile oder der Wedge selbst übermäßig aufgeheizt werden. Die Laserenergie wird erfindungsgemäß auf die Verbindungsstelle des Bonddraht-Abschnitts mit dem Bondpad unterhalb dem Wedge konzentriert bzw. gebündelt. Auf diese Weise kommt man mit einer im Vergleich zum Stand der Technik um einen Faktor 10 bis 20 reduzierten Laserleistung aus.

Nachstehend wird die Erfindung anhand eines erfindungsgemäß modifizierten Kontaktierwerkzeuges (Wedge) und einer erfindungsgemäß modifizierten Bondeinheit unter Hinweis auf die anliegende Zeichnung näher erläutert. Diese zeigt in
Fig. 1 ein Ausführungsbeispiel eines erfindungsgemäß modifizierten Bondwerkzeugs und die Anordnung der Komponenten in schematischer Seitenansicht;
Fig. 2 ein Ausführungsbeispiel einer erfindungsgemäß modifizierten Bondeinheit in schematischer Gesamtübersicht;
Fig. 3 den Temperaturverlauf über die Zeit an zwei in Fig. 1 gekenntzeichneten Meßpunkten am Bonddraht selbst einerseits und am Wedge andererseits bei Anwedung des erfindungsgemäßen Thermokompressionsbondens; und
Fig. 4 die räumliche Temperaturverteilung in der Vorrichtung gemäß Fig. 1.

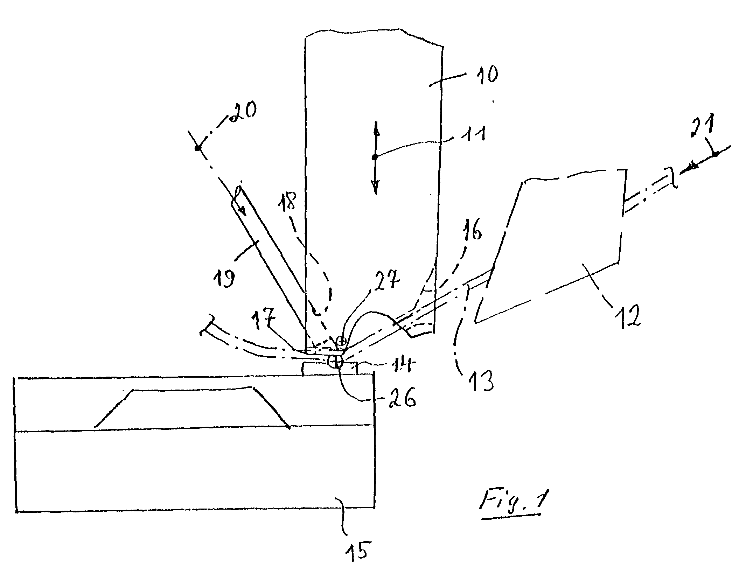

Das Vorrichtungs- und Verfahrensprinzip der vorliegenden Erfindung ist in Fig. 1 schematisch dargestellt. Da es sich bei der erfindungsgemäßen Vorrichtung um eine modifizierte konventionelle Wedge-Bondeinheit handelt, genügt hier ein Hinweis auf die wesentlichen Teile dieser Einheit wie folgt:
- 10 =: auf- und abbewegbarer Wedge
- 11 =: Doppelpfeil (zeigt die Auf- und Abbewegung des Wedge 10 an)
- 12 =: Drahtklemme
- 13 =: Bonddraht
- 14 =: Bondpad (Bondstelle)
- 15 =: Drucksensor
- 16 =: Drahtzuführung
- 17 =: Drahtführung an der unteren Kontaktseite des Wedge.

An der der Drahtzuführung 16 gegenüberliegenden Seite ist im Wedge eine sich im spitzen Winkel zur Vertikalen erstreckende Bohrung 18 ausgebildet, in die ein hochflexibler Lichtwellenleiter 19 eingebracht ist, und zwar soweit, daß sich das freie Ende des Lichtwellenleiters bis unmittelbar zur unteren Kontaktseite des Wedge 10 erstreckt. Der Lichtwellenleiter 19 hat einen Durchmesser von etwa 100 µm. Der Laserstrahl, der durch den Lichtwellenleiter 19 hindurch geführt wird, ist in Fig. 1 mit der Bezugsziffer 20 angedeutet. Des weiteren ist in Fig. 1 mit dem Pfeil 21 die Transportrichtung des Bonddrahtes dargestellt. Der Bonddraht hat einen Durchmesser von etwa 75 µm. Das Bondpad 14 hat eine Grundfläche von etwa 200 x 200 µm².

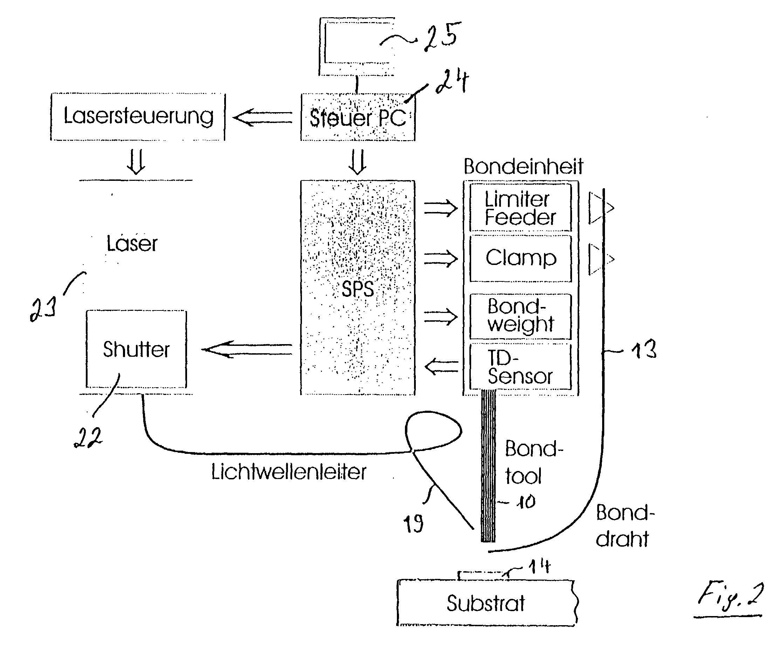

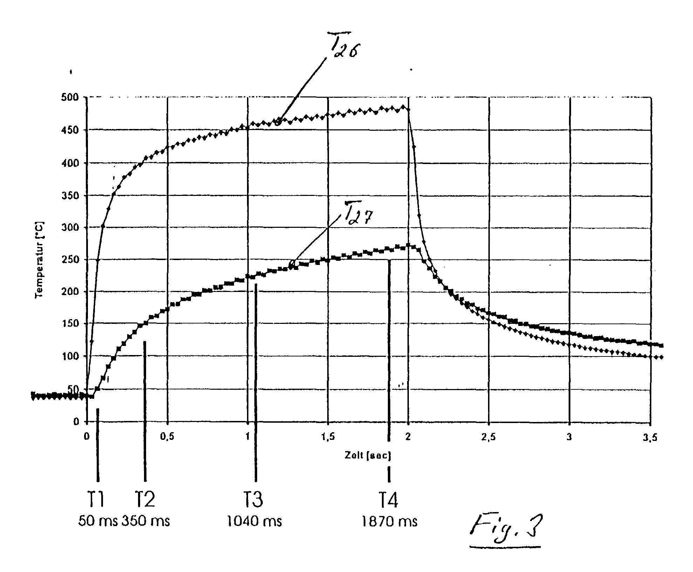

Fig. 2 zeigt ein Blockschaltbild des Aufbaus zur Durchführung des erfindungsgemäßen Thermokompressionsbondens. Die zur Durchführung des Bondprozeßes benötigten Funktionen wie
- Anpresskraft (Bondweight)
- Drahtvorschub (Clamp)
- Hubbegrenzung (Limitater Feeder) sowie
- die Messung der Drahtverformung (Touch Down Sensor = TD-Sensor)
werden durch eine kommerziell verfügbare Bondeinheit realisiert. Die Positionierung der Bondeinheit erfolgt z.B. durch einen Sechsachspräzisionsroboter. Das Gesamtsystem, bestehend aus Präzisionsroboter, der in Fig. 2 nicht dargestellt ist, Laserstrahlquelle und Bondeinheit, wird über einen Steuer-PC (Personal Computer) und eine rechnergestützte SPS-Steuerung gesteuert. Entscheidend für die Qualität und die Reproduzierbarkeit der Bondverbindung ist die zeitliche und räumliche Temperaturverteilung am Wedge und im Kontaktsystem. In Fig. 2 ist der Wedge mit der Bezugsziffer 10 gekennzeichnet. Der Lichtwellenleiter 19 ist über einen optischen Schalter 22 mit einer Laserstrahlquelle 23, z.B. Laserdiode, gekoppelt. Die Ansteuerung der Laserstrahlquelle erfolgt über den erwähnten Steuer-PC, der in Fig. 2 mit der Bezugsziffer 24 gekennzeichnet ist. An den Steuer-PC 24 ist ein Monitor 25 gekoppelt.

Da alle anderen Bestandteile der Bondeinheit per se bekannt sind, erübrigt sich hier eine nähere Erläuterung -derselben. Fig. 2 soll auch nur eine Übersicht über die Verknüpfung einer herkömlichen Bondeinheit mit der erfindungsgemäßen Laserstrahl-Einheit vermitteln.

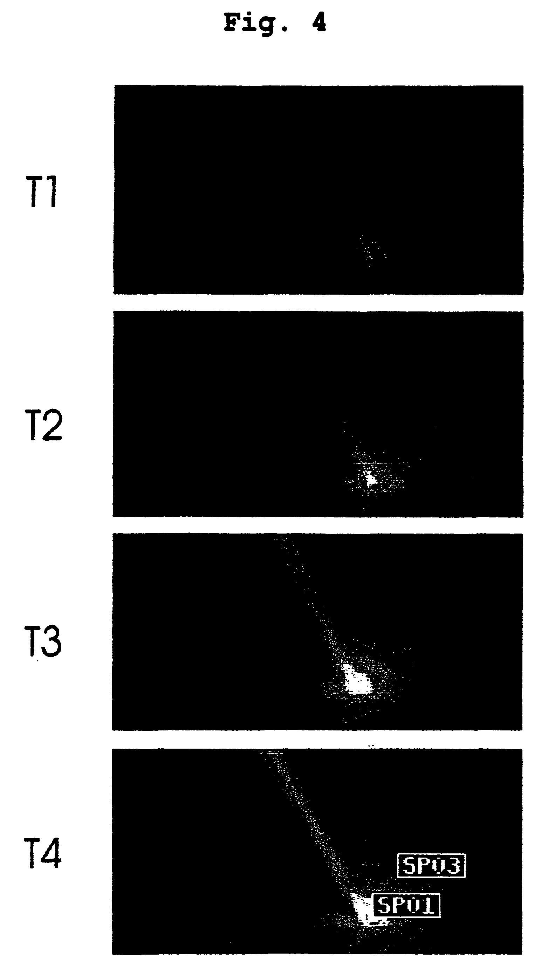

Fig. 3 zeigt die zeitlichen Temperaturverläufe in den beiden in Fig. 1 gekennzeichneten Meßpunkten 26 und 27. Diese Temperaturverläufe sind mit T₂₆ einerseits und T₂₇ dargestellt. Der Meßpunkt 26 liegt an der durch den Laserstrahl aufgeheizten Kontaktstelle des Bonddrahtes mit dem zugeordneten Bondpad 14, während sich der Meßpunkt 27 im Wedge 10 befindet, und zwar in unmittelbarer Nähe zu dem durch den Laserstrahl aufgeheizten Abschnitt des Bonddrahtes. Die zum Thermokompressionsbonden benötigte Temperatur von etwa 350 °C am Meßpunkt 26 wird bereits nach etwa 150 ms erreicht. Nach 2 Sekunden erhält man mit einer Strahlungsleistung von etwa 2 Watt im Kontaktsystem eine Gleichgewichtstemperatur von etwa 500 °C. Der Temperaturanstieg im Wedge nahe der Kontaktstelle ist deutlich niedriger, wie der Temperaturverlauf T₂₇ in Fig. 3 zeigt.

Fig. 3 läßt erkennen, daß das erfindungsgemäße Verfahren durch kurze Temperatur-Anstiegszeiten und einen geringen Leistungsbedarf gekennzeichnet ist. Natürlich wird die Temperatur der Kontaktstelle während des Bondprozeßes bestimmt von der eingekoppelten Strahlungsleistung und den Eigenschaften des Kontaktsystems selbst, wie dessen Geometrie, Materialzusammensetzung und Wärmeleitfähigkeit. Je höher die Strahlungsleistung ist, desto geringer kann die Bondzeit gewählt werden.

Zusammenfassend kann festgestellt werden, daß das erfindungsgemäße laserunterstützte Drahtbonden eine wirtschaftlich vorteilhafte Variante des sogenannten Thermokompressionsbondens ist, bei der die Mikroverbindungen durch lokale und kurzzeitige Erwärmung des Kontaktsystems mit Hilfe von Laserstrahlung hergestellt werden. Der laserunterstützte Bondprozeß kann unter Verwendung von technisch etablierten Steuerungskonzepten und kommerziell verfügbaren Komponenten in modifizierter Form erreicht werden. Im Vergleich zum Stand der Technik läßt sich die benötigte Laserleistung auf 1/10 bis 1/20 reduzieren. Damit werden die technischen und wirtschaftlichen Vorraussetzungen für die Integration von preisgünstigen Laserstrahlquellen in konventionelle und am Markt etablierten Montage- und Fügestationen geschaffen. Hierfür kommen miniaturisierte Strahlquellen, wie z.B. IR-Diodenlaser mit Ausgangsleistungen von etwa 5 Watt in Frage. Wesentliche Vorteile des laserunterstützten Drahtbondens, wie große Werkstoffauswahl, hohe Stabilität und breites Prozeßfenster und insbesondere die Möglichkeit der Verarbeitung von lackisolierten Drähten sprechen für eine industrielle Anwendung des beschriebenen Verfahrens bei der Herstellung von hybridaufgebauten Mikrosystemen, z.B. Smart-Cards.

Fig. 3 läßt noch erkennen, daß das beschriebene Verfahren durch scharfe Temperaturprofile gekennzeichnet ist, wobei die Erwärmung des Bonddrahts auf den Kontaktbereich desselben fokussiert ist.

Fig. 1 zeigt sehr deutlich, daß sich die beschriebene Vorrichtung äußerst einfach herstellen läßt, insbesondere durch einfache Modifikation einer herkömlichen Bondeinheit bzw. eines herkömlichen Kontaktierwerkzeuges (Wedge). Der Lichtwellenleiter 19 wird vorzugsweise mittels einer Klemmvorrichtung am Wedge 10 befestigt oder in die Wedge-Bohrung 18 eingeklebt. Aufgrund der Flexibilität des Lichtwellenleiters 19 läßt sich der Wedge 10 ungehindert in herkömlicher Weise bewegen.

Fig. 4 zeigt Thermographie-Aufnahmen zu den Zeitpunkten T1 bis T4 gemäß Fig. 3, wobei hellere Punkte einer höheren Temperatur zugeordnet sind. Der hellste Punkt zur Zeit T4 entspricht einer Temperatur von etwa 500 °C.

### Bezugszeichenliste

- 10: Kontaktierwerkzeug (Wedge)
- 11: Doppelpfeil
- 12: Drahtklemme
- 13: Bonddraht
- 14: Bondpad (Bondstelle)
- 15: Drucksensor
- 16: Drahtzuführung
- 17: Drahtführung an der unteren Kontaktseite des Wedge (Drahtführungsnut)
- 18: Bohrung
- 19: Lichtwellenleiter
- 20: Laserstrahl
- 21: Pfeil
- 22: Shutter bzw. optischer Schalter
- 23: Laserstrahlquelle
- 24: Steuer-PC
- 25: Monitor
- 26: Meßpunkt
- 27: Meßpunkt

## Patentansprüche

1. Vorrichtung zum Thermokompressionsbonden mit einem gegen eine Bondstelle verfahrbaren Kontaktierwerkzeug bzw. Wedge (10) und einem diesem zugeordneten, mit einer Laserstrahlquelle (23) gekoppelten sowie auf einen unterhalb des Wedge (10) zwischen diesem und der Bondstelle (14) angeordneten Bonddraht-Abschnitt gerichteten Lichtwellenleiter (19), wobei der Lichtwellenleiter (19) durch den Wedge (10) hindurch bis nahe an den sich unterhalb des Wedge (10) befindlichen Bonddraht-Abschnitts (26) herangeführt ist, so daß im wesentlichen nur dieser Abschnitt bei Einkoppelung von Laserenergie auf eine zum Thermokompressionsbonden ausreichende Temperatur erwärmbar ist,
**dadurch gekennzeichnet,**
**daß** der Lichtwellenleiter (19) an der eine Drahtzuführung (16) gegenüberliegenden Seite des Wedge (10) in diesen eingeführt ist, insbesondere unter einem Winkel von 30° bis 50°, insbesondere etwa 40° bis 45° zur Vertikalen bzw. Anpreßrichtung (11) des Wedge (10).

2. Vorrichtung nach Anspruch 1,
**dadurch gekennzeichnet,**
**daß** der Lichtwellenleiter (19) über einen optischen Schalter (22) mit der Laserstrahlquelle (23), insbesondere Laserdiode, gekoppelt ist,-wobei die Laserstrahlquelle und/oder Shutter durch eine Steuereinrichtung (24) in Abhängigkeit vom Bondzyklus anteuerbar ist bzw. sind.

3. Vorrichtung nach Anspruch 1 oder 2,
**dadurch gekennzeichnet,**
**daß** die Laserstrahlquelle (23) eine Ausgangsleistung von etwa 2 bis 5 Watt aufweist.

4. Vorrichtung nach einem der Ansprüche 1 bis 3,
**dadurch gekennzeichnet,**
**daß** der Lichtwellenleiter (19) insbesondere mittels einer Klemmvorrichtung am Wedge (10) befestigt oder am Wedge angeklebt ist.

5. Thermokompressionsbonden mit einer Vorrichtung nach einem der Ansprüche 1 bis 4, wobei ein unter dem Wedge (10) befindlicher Bonddraht-Abschnitt bei Einkopplung von Laserenergie auf eine zum Thermokompressionsbonden ausreichend hohe Temperatur, insbesondere auf eine Temperatur von etwa 300°C bis 500°C, vorzugsweise etwa 350°C erwärmt wird, bevor der Bonddraht durch den Wedge (10) auf eine Bondstelle (14) gepreßt und mit dieser verschweißt wird.

6. Thermokompressionsbonden nach Anspruch 5,
**dadurch gekennzeichnet,**
**daß** die Laserenergie für eine Zeitspanne von etwa 100 ms bis 300 ms, insbesondere etwa 150 ms, eingekoppelt wird.

## Claims

1. A device for thermocompression bonding, comprising a contacting tool or wedge (10) movable towards a bond point, and a light wave guide (19) associated therewith and connected to a laser beam source (23) and directed at a bonding wire portion arranged below the wedge (10) between the latter and the bond point (14), wherein the light wave guide (19) extends through the wedge (10) into the vicinity of the bonding wire portion (26) below the wedge (10) so that substantially only this portion can be heated up to a temperature sufficient for thermocompression bonding when the laser energy is concentrated, **characterised in that** the light wave guide (19) is inserted into the wedge (10) on the side thereof opposite a wire supply (16), in particular at an angle of 30° to 50°, in particular approximately 40° to 45° to the vertical or contact direction (11) of the wedge (10).

2. A device according to claim 1, **characterised in that** the light wave guide (19) is connected to the laser beam source (23), in particular a laser diode, by an optical switch (22), the laser beam source and/or shutter being activatable by a control device (24) as a function of the bond cycle.

3. A device according to claim 1 or 2, **characterised in that** the laser beam source (23) has an output of around 2 to 5 watts.

4. A device according to any one of claims 1 to 3, **characterised in that** the light wave guide (19) is fixed to the wedge (10), in particular by means of a clamping device, or is glued to the wedge.

5. Thermocompression bonding using a device according to any one of claims 1 to 4, wherein, when the laser energy is concentrated, a bonding wire portion under the wedge (10) is heated up to a sufficiently high temperature for thermocompression bonding, in particular to a temperature of approximately 300°C to 500°C, preferably approximately 350°C, before the bonding wire is pressed by the wedge (10) onto a bond point (14) and welded thereto.

6. Thermocompression bonding according to claim 5, **characterised in that** the laser energy is concentrated for a period of about 100 ms to 300 ms, in particular about 150 ms.

## Revendications

1. Disposltif de liaison par thermocompression comportant un outil de mise en contact ou wedge (10), déplaçable vers un emplacement de liaison, et un guide d'ondes de lumlère (19) associé à celui-ci, accouplé à une source de rayons laser (23) et dirigé sur une portion de fil de liaison disposée au-dessous du wedge (10) entre ce dernier et l'emplacement de liaison (14), le guide d'ondes de lumière (19) étant approché, à travers le wedge (10), jusqu'à proximité de la portion de fil de liaison (26) se trouvant au dessous du wedge (10), de sorte que pour l'essentiel seule cette portion peut être échauffée à une température suffisante pour la liaison par thermocompression, lorsqu'on introduit de l'énergie laser,
**caractérisé**
**en ce que** le guide d'ondes de lumière (19) est introduit dans le wedge (10), sur un côté de celui-ci opposé à une arrivée de fil (16), en particulier suivant un angle de 30° à 50°, en particulier d'environ 40° à 45° par rapport à la verticale, respectivement à la direction de pression (11) du wedge (10).

2. Dispositif selon la revendication 1,
**caractérisé**
**en ce que** le guide d'ondes de lumière (19) est accouplé à la source de rayons laser (23), en particulier diode laser, par un interrupteur optique (22), la source de rayon laser et/ou des shutters pouvant être commandés par un dispositif de commande (24), en fonction du cycle de liaison.

3. Dispositif selon la revendication 1 ou 2,
**caractérisé**
**en ce que** la source de rayon laser (23) présente une puissance de sortie d'environ 2 à 5 Watts.

4. Dispositif selon l'une des revendications 1 à 3,
**caractérisé**
**en ce que** le guide d'ondes de lumière (19) est fixé à l'outil de contact (10), en particulier au moyen d'un dispositif de serrage, ou est collé à l'outll de contact (10).

5. Procédé de liaison par thermocompression avec un dispositif selon l'une des revendications 1 à 4, dans lequel une portion de fil de liaison, se trouvant sous l'outil de contact (10), est chauffée, par apport d'énergie laser, à une température suffisamment élevée pour la liaison par themocompression, en particulier à une température de 300 °C à 500 °C, de préférence à environ 350 °C, avant que le fil de liaison ne soit pressé par l'outil de contact (10) sur un emplacement de liaison (14) et ne soit soudé avec celui-ci.

6. Procédé de liaison par thermocompression selon la revendication 5,
**caractérisé**
**en ce que** l'énergle laser est introduite pendant un intervalle de temps d'environ 100 ms à 300 ms, en particulier d'environ 150 ms.
